# EUROPÄISCHE PATENTSCHRIFT

(11) **EP 4 009 457 B1**
(45) Veröffentlichungstag und Bekanntmachung des Hinweises auf die Patenterteilung: **12.04.2023**
(21) Anmeldenummer: 21211581.0
(22) Anmeldetag: 01.12.2021
(51) Int. Cl.: H02B 1/052, H02B 1/01, H05K 7/18

(54) **BEFESTIGUNGSEINRICHTUNG, VERFAHREN ZUM BEFESTIGEN EINER TRAGSCHIENE AN EINER FLÄCHE, ANORDNUNG SOWIE SCHALTSCHRANK**
FASTENING DEVICE, METHOD FOR FIXING A SUPPORT RAIL TO A SURFACE, ARRANGEMENT AND SWITCH CABINET
DISPOSITIF DE FIXATION, PROCÉDÉ DE FIXATION D'UN RAIL PORTEUR À UNE SURFACE, AGENCEMENT, AINSI QU'ARMOIRE DE COMMANDE

(30) Priorität: 03.12.2020 DE 102020132090
(43) Veröffentlichungstag der Anmeldung: 08.06.2022
(73) Patentinhaber: Phoenix Contact GmbH & Co. KG, 32825 Blomberg (DE)
(72) Erfinder: KLOPPENBURG, Christian, 33142 Büren Wewelsburg (DE); Janzen, Wjatscheslaw, 32758 Detmold (DE); GEBHARDT, Martin, 32457 Porta Westfalica (DE)

(56) Entgegenhaltungen:
- CN-A- 103 532 030
- DE-A1- 1 775 270
- DE-A1- 2 746 545
- GB-A- 544 284
- US-A- 4 471 930

## Beschreibung

Die Erfindung betrifft eine Befestigungseinrichtung zum Befestigen einer Tragschiene an einer Fläche, beispielsweise einer Wand oder einer Montagplatte eines Schaltschranks. Weiter betrifft die Erfindung ein Verfahren zum Befestigen einer Tragschiene an einer Fläche mittels einer derartigen Befestigungseinrichtung sowie eine Anordnung und einen Schaltschrank mit einer derartigen Befestigungseinrichtung.

Tragschienen können als ein längliches U- oder C-Profil ausgebildet sein und dienen dazu, eine Vielzahl von Anschlussklemmen, insbesondere Reihenklemmen, aufzunehmen. Über die Tragschienen können die Anschlussklemmen in einem Schaltschrank montiert werden. Die Tragschienen weisen meist eine Vielzahl von Öffnungen auf, über welche die Tragschienen mittels Schrauben an einer Wand des Schaltschranks befestigt werden können. Da die Schrauben nicht mehr zugänglich sind, wenn die Tragschienen mit Anschlussklemmen bestückt sind, müssen die Tragschienen zunächst im Schaltschrank mittels der Schrauben befestigt werden und erst nach der Befestigung bzw. Montage der Tragschienen an einer Wand des Schaltschranks können die Tragschienen mit den Anschlussklemmen bestückt werden. Oder es müssen bei einem vorkonfektionierten Tragschienensystem zuerst ein paar Anschlusselemente von der Tragschiene demontieren, um die Tragschiene zum Beispiel mit einer Schraube an der Fläche bzw. der Wand fixieren zu können. Eine mit Anschlussklemmen vorkonfektionierte Tragschiene kann damit nur schwer in dem Schaltschrank montiert werden. Dadurch ist auch keine automatisierte Bestückung der Tragschienen möglich. Der Montageaufwand zum Bestücken eines Schaltschranks mit Anschlussklemmen und Tragschienen ist dadurch sehr hoch. Einige Beispiele bekannter Befestigungseinrichtungen für Tragschienen sind in CN103532030A und DE2746545A1 offenbart. Spezifische mechanische Details von Linearsicherungselementen, die durch ein Drehbewegung betätig werden, sind in US4471930A, DE1775270A1 und GB544284A offenbart.

Der Erfindung liegt die Aufgabe zu Grunde, eine Befestigungseinrichtung, ein Verfahren, eine Anordnung sowie einen Schaltschrank zur Verfügung zu stellen, bei welchen der Montageaufwand reduziert werden kann und insbesondere mit Anschlussklemmen vorkonfektionierte Tragschienen an einer Fläche, wie einer Wand oder einer Montageplatte, möglichst spielfrei befestigt werden können.

Die Aufgabe wird erfindungsgemäß mit den Merkmalen der unabhängigen Ansprüche 1 und 14 gelöst. Zweckmäßige Ausgestaltungen und vorteilhafte Weiterbildungen der Erfindung sind in den Unteransprüchen angegeben.

Die Befestigungseinrichtung weist ein an der Fläche befestigbares Befestigungselement auf, welches eine Tragschienenauflagefläche zur Auflage der Tragschiene und einen Tragschienenbefestigungsabschnitt aufweist, wobei der Tragschienenbefestigungsabschnitt in einem befestigten Zustand zumindest bereichsweise durch eine an der Tragschiene ausgebildete Öffnung hindurchgeführt ist und wobei der Tragschienenbefestigungsabschnitt einen Hintergriff aufweist, in welchen in dem befestigten Zustand ein Abschnitt der Tragschiene eingeschoben ist. Weiter weist die Befestigungseinrichtung eine Sicherungseinrichtung auf, wobei die Sicherungseinrichtung ein Sicherungselement aufweist, welches derart ausgebildet ist, dass durch eine Drehbewegung des Sicherungselements eine Linearbewegung zwischen dem Befestigungselement und der Tragschiene derart erfolgt, dass die Tragschiene in den Hintergriff des Tragschienenbefestigungsabschnitts eingeschoben und verspannt wird.

Zur Befestigung der Tragschiene an einer Fläche, insbesondere einer Wand oder einer Montageplatte eines Schaltschranks, ist nunmehr eine Befestigungseinrichtung mit mindestens einem Befestigungselement vorgesehen, wobei das eine oder die mehreren Befestigungselemente zunächst an der Fläche befestigt wird bzw. werden und anschließend die vorkonfektionierte, beispielsweise mit Anschlussklemmen bestückte Tragschiene an dem einen oder an den mehreren Befestigungselementen und damit an der Fläche befestigt wird. Die Tragschiene kann in das an der Wand befestigte Befestigungselement eingeschoben werden, so dass die Tragschiene durch das Einschieben in das Befestigungselement der Befestigungseinrichtung an der Wand gehalten und befestigt werden kann. Sonst übliche Befestigungsmittel, wie beispielsweise mehrere Schrauben, müssen an der Tragschiene nicht mehr befestigt werden, um die Tragschiene an der Fläche zu befestigen. Dies führt zu einer wesentlichen Vereinfachung der Montage der Tragschiene an einer Fläche.

Die Anschlussklemmen sind im Bereich eine Oberseite der Tragschiene auf der Tragschiene aufgerastet. Die Montage der Tragschiene an der Fläche erfolgt über eine der Oberseite gegenüberliegende Unterseite der Tragschiene, an welcher gerade keine Anschlussklemmen aufgerastet sind. Über die Unterseite wird das Befestigungselement mit seinem Tragschienenbefestigungsabschnitt durch eine Öffnung der Tragschiene geführt, so dass in dem befestigten Zustand das Befestigungselement mit seinem Tragschienenbefestigungsabschnitt zumindest bereichsweise durch die Öffnung der Tragschiene hindurchragt. Entlang der Länge der Tragschiene weist diese vorzugsweise mehrere dieser Öffnungen auf, wobei in jeder Öffnung ein derartiges Befestigungselement angeordnet sein kann, um die Tragschiene an der Wand zu befestigen. Die Befestigungseinrichtung kann damit auch zwei oder mehrere derartiger Befestigungselemente aufweisen. Die Öffnungen an der Tragschiene sind vorzugsweise jeweils länglich ausgebildet, so dass sie eine größere Länge als Breite aufweisen. Entlang seiner Länge weist der Tragschienenbefestigungsabschnitt einen Hintergriff auf, in welchen ein an die Öffnung angrenzender Abschnitt der Tragschiene bei der Montage eingeschoben werden kann, so dass die Tragschiene in dem befestigten Zustand in Eingriff mit dem Hintergriff und über den Hintergriff an der Befestigungseinrichtung über das Befestigungselement der Befestigungseinrichtung gehalten ist. Die Tragschiene kann dadurch über eine rein formschlüssige Verbindung an dem Befestigungselement der Befestigungseinrichtung und damit an der Fläche gehalten und befestigt sein. Durch eine derartige Befestigungseinrichtung können bereits mit Anschlussklemmen bestückte Tragschienen, sogenannte vorkonfektionierte Tragschienen, schnell und einfach und damit mit einem geringen Montageaufwand an einer Fläche befestigt werden.

Um ein ungewolltes Herausrutschen der Tragschiene aus dem Hintergriff der Befestigungselemente verhindern zu können, weist die Befestigungseinrichtung weiter eine Sicherungseinrichtung auf. Die Sicherungseinrichtung ermöglicht ein spielfreies Verspannen der Tragschiene an dem Befestigungselement, insbesondere in dem Hintergriff des Tragschienenbefestigungsabschnitts des Befestigungselements. Die Sicherungseinrichtung weist ein Sicherungselement auf, welches drehbar gelagert. Beispielsweise kann das Sicherungselements drehbar an der Fläche gelagert sein, an welcher die Montage der Tragschiene erfolgt. Das Sicherungselement wirkt derart mit dem Befestigungselement und/oder der Tragschiene zusammen, dass durch die Drehbewegung des Sicherungselements eine Linearbewegung zwischen dem Befestigungselement und der Tragschiene bewirkt wird, wobei durch diese Linearbewegung die Tragschiene weiter in den Hintergriff des Tragschienenbefestigungsabschnitts eingeschoben wird, so dass ein spielfreies Verspannen der Tragschiene in den Hintergriff erfolgen kann. Die Linearbewegung erfolgt in Längserstreckungsrichtung der Tragschiene. Das Sicherungselement kann bei seiner Drehbewegung entweder unmittelbar auf das Befestigungselement einwirken, um das Befestigungselement und damit den Tragschienenbefestigungsabschnitt mit seinen Hintergriff derart linear zu bewegen, dass der Tragschienenbefestigungsabschnitt weiter auf den Abschnitt der Tragschiene aufgeschoben wird, so dass der Abschnitt der Tragschiene tiefer in den Hintergriff eintaucht. Weiter ist es auch möglich, dass das Sicherungselement bei seiner Drehbewegung unmittelbar auf die Tragschiene einwirkt und dadurch derart gegen die Tragschiene drückt, dass die Tragschiene linear bewegt wird und dadurch weiter in Richtung des Tragschienenbefestigungsabschnitt und damit tiefer in den Hintergriff eingeschoben wird.

Der Hintergriff kann in Form einer an einer Außenumfangsfläche des Tragschienenbefestigungsabschnitts ausgebildeten Aussparung ausgebildet sein. Der Tragschienenbefestigungsabschnitt kann eine zylindrische und damit längliche Form aufweisen, welche beispielsweise einen runden oder ellipsenförmigen Querschnitt aufweisen kann. Die Aussparung kann an der Außenumfangsfläche dieser zylindrischen Form ausgebildet sein. Die Aussparung kann in Form einer Einkerbung an der Außenumfangsfläche des Tragschienenbefestigungsabschnitts ausgebildet sein. Die Aussparung erstreckt sich ausgehend von der Außenumfangsfläche in Richtung einer Mittelachse des Tragschienenbefestigungsabschnitts. Durch die Aussparung kann der Tragschienenbefestigungsabschnitt einen sich parallel zu der Längsachse der Tragschiene erstreckenden Zapfen aufweisen, an dessen im befestigten Zustand in Richtung Tragschiene gerichteten Unterseite der Hintergriff ausgebildet sein kann.

Die Aussparung kann sich ausgehend von der Außenumfangsfläche des Tragschienenbefestigungsabschnitts in Richtung der Mittelachse des Tragschienenbefestigungsabschnitts verjüngen. Durch die Verjüngung kann eine gezielte Einführung des Abschnitts der Tragschiene in den Hintergriff hinein erfolgen. Zudem kann das Einführen des Abschnitts der Tragschiene in den Hintergriff erleichtert werden.

Die Hintergriff kann durch mindestens eine Wandfläche begrenzt sein, wobei die Wandfläche eine Rampenform aufweisen kann. Die Wandfläche bildet vorzugsweise die im befestigten Zustand in Richtung Tragschiene gerichtete Unterseite des Zapfens aus. Durch die Rampenform kann die Wandfläche eine Schrägfläche ausbilden. Die Wandfläche kann sich beispielsweise in einem Winkel zwischen 30° und 80°, bevorzugt zwischen 40° und 70°, zu der Mittelachse erstrecken. Durch die Rampenform können Toleranzen der Tragschiene ausgeglichen werden. Zudem können dadurch an dem Befestigungselement der Befestigungseinrichtung Tragschienen mit unterschiedlichen Materialstärken befestigt werden.

Die Sicherungseinrichtung kann eine Betätigungsfläche aufweisen, welche mit dem Befestigungselement oder der Tragschiene zusammenwirken kann, um die Linearbewegung zu bewirken. Über die Betätigungsfläche kann die Sicherungseinrichtung unmittelbar auf die Tragschiene oder das Befestigungselement einwirken, um die Linearverschiebung zwischen der Tragschiene und dem Befestigungselement bewirken zu können. Die Betätigungsfläche liegt dafür vorzugsweise unmittelbar an der Tragschiene oder dem Befestigungselement an, wobei eine Drehbewegung des Sicherungselements ein Entlanggleiten der Betätigungsfläche entlang der Tragschiene oder des Befestigungselements bewirken kann.

Die Betätigungsfläche kann vorzugsweise in Form einer Schrägfläche ausgebildet sein. Die Schrägfläche weist vorzugsweise eine Neigung auf. Die Neigung ist vorzugsweise derart ausgebildet, dass zwischen einer Längsachse der Sicherungseinrichtung, insbesondere einer Längsachse des Sicherungselements, ein Winkel ausgebildet ist, wobei dieser Winkel vorzugsweise < 90°, insbesondere zwischen 10° ≤ α ≤ 70°, bevorzugt zwischen 20° ≤ α ≤ 55°, besonders bevorzugt zwischen 25° ≤ α ≤ 45°, beträgt. Die Schrägfläche erleichtert das Aufbringen einer Schiebekraft auf das Befestigungselement oder die Tragschiene, um die Linearbewegung zwischen dem Befestigungselement und der Tragschiene zu bewirken. Bei einer Drehbewegung des Sicherungselements kann die Sicherungseinrichtung bzw. ein Teil der Sicherungseinrichtung, an welchem die Schrägfläche ausgebildet ist, entlang der Längsachse der Sicherungseinrichtung bewegt werden, wodurch die Schrägfläche eine Druckkraft und damit eine Schiebekraft auf das Befestigungselement oder die Tragschiene aufbringen kann.

Wirkt die Sicherungseinrichtung direkt mit dem Befestigungselement zusammen, um das Befestigungselement derart relativ zu der Tragschiene zu bewegen bzw. zu verschieben, dass der Abschnitt der Tragschiene weiter in den Hintergriff wandern kann, kann das Befestigungselement eine Gleitfläche aufweisen, welche mit der Betätigungsfläche der Sicherungseinrichtung zusammenwirken kann. Um die Linearbewegung zwischen dem Befestigungselement und der Tragschiene zu bewirken, kann die Sicherungseinrichtung mit ihrer Betätigungsfläche entlang der Gleitfläche gleiten bzw. wandern. Die Sicherungseinrichtung liegt hiervor vorzugsweise flächig an der Gleitfläche an.

Die Gleitfläche weist vorzugsweise die gleiche Neigung auf wie die Betätigungsfläche. Ist die Betätigungsfläche als Schrägfläche ausgebildet, ist auch die Betätigungsfläche vorzugsweise schräg bzw. geneigt ausgebildet, so dass die Gleitfläche vorzugsweise den gleichen Neigungswinkel aufweist wie die als Schrägfläche ausgebildete Betätigungsfläche.

Beispielsweise kann die Gleitfläche an dem Tragschienenbefestigungsabschnitt ausgebildet sein. Wirkt die Sicherungseinrichtung mit dem Befestigungselement zusammen, kann die Sicherungseinrichtung damit unmittelbar auf den Tragschienenbefestigungsabschnitt, an welchem der Hintergriff ausgebildet ist, eine Kraft, insbesondere eine Drucckraft, aufbringen, um das Befestigungselement relativ zu der Tragschiene zu verschieben. Damit kann ein kurzer Kraftweg erzielt werden, wodurch die Höhe der notwendigen aufzubringenden Kraft reduziert werden kann. Die Gleitfläche ist vorzugsweise an einer dem Hntergriff abgewandten Seitenfläche des Tragschienenbefestigungsabschnitts ausgebildet.

Das Sicherungselement kann beispielsweise eine Schraube sein, welche einen Schraubenkopf und einen Schraubenschaft aufweist. An dem Schraubenschaft ist vorzugsweise ein Gewinde ausgebildet, über welches die Schraube und damit das Sicherungselement in die Fläche, an welcher die Tragschiene befestigt werden soll, eingeschraubt werden kann.

Ist das Sicherungselement eine Schraube, so kann an dem Schraubenkopf die Betätigungsfläche ausgebildet sein. Bei einer Drehbewegung der Schraube kann dann der Schraubenkopf direkt oder indirekt auf das Befestigungselement oder die Tragschiene wirken, um die Linearbewegung zwischen Befestigungselement und Tragschiene zu bewirken. Durch die Ausbildung der Betätigungsfläche an dem Schraubenkopf, kann der Schraubenschaft alleine die Funktion einer sicheren Befestigung an der Fläche aufweisen.

Ist die Betätigungsfläche an dem Schraubenkopf ausgebildet und ist die Betätigungsfläche in Form einer Schrägfläche ausgebildet, kann der Schraubenkopf eine konische Form aufweisen. Durch die konische Form kann sich die Schrägfläche um die gesamte Außenumfangsfläche des Schraubenkopfes erstrecken. Die konische Form ist vorzugsweise derart ausgebildet, dass sich der Schraubenkopf in Richtung der Anbindung des Schraubenkopfes an den Schraubenschaft verjüngt. Dieser konisch geformte Schraubenkopf kann sowohl auf die Tragschiene als auch auf das Befestigungselement einwirken, um die Linearbewegung zwischen Tragschiene und Befestigungselement bewirken zu können.

Weiter kann es auch vorgesehen sein, dass die Betätigungsfläche nicht an dem Sicherungselement angeordnet ist, sondern dass die Sicherungseinrichtung ein an dem Sicherungselement angeordnetes Betätigungselement aufweist, an welchem die Betätigungsfläche ausgebildet sein kann. Das Sicherungselement wirkt dann durch seine Drehbewegung indirekt auf die Tragschiene oder auf das Befestigungselement um die Linearbewegung zwischen Tragschiene und Befestigungselement zu realisieren. Das Sicherungselement wirkt direkt auf das Betätigungselement und das Betätigungselement wirkt wiederum direkt auf die Tragschiene oder auf das Befestigungselement. Das Betätigungselement kann derart an dem Sicherungselement angeordnet sein, dass bei einer Drehbewegung des Sicherungselements das Betätigungselement mit dem Sicherungselement bei einer axialen Bewegung mitgeführt wird, so dass das Betätigungselement bei dieser axialen Bewegung, welche entlang der Längsachse der Sicherungselements verläuft, die Linearbewegung zwischen dem Befestigungselement und der Tragschiene bewirken kann. Die axiale Bewegung des Betätigungselements ist vorzugsweise quer zu der Linearbewegung zwischen dem Befestigungselement und der Tragschiene ausgerichtet.

Das Betätigungselement kann beispielsweise derart ausgebildet sein, dass das Betätigungselement einen ersten Schenkel aufweist, über welchen das Betätigungselement an dem Sicherungselement angeordnet ist, und das Betätigungselement einen zweiten Schenkel aufweist, an welchem die Betätigungsfläche ausgebildet ist, wobei der zweite Schenkel zu dem ersten Schenkel abgewinkelt angeordnet sein kann. Der abgewinkelt ausgebildete zweite Schenkel kann dann eine Schrägfläche als Betätigungsfläche ausbilden. Das Betätigungselement kann hierbei beispielsweise ein Blech sein, welches gestanzt und die gewünschte Form gebogen ist. Das Betätigungselement kann damit ein Stanz-Biegeteil sein. Das Sicherungselement kann hierbei eine Schraube sein, wobei die Schraube eine Standardschraube sein kann und damit keinen konisch geformten Schaubenkopf aufweisen muss. Das Betätigungselement kann an dem Schraubenschaft des Sicherungselements angeordnet sein, indem der erste Schenkel des Betätigungselements eine Öffnung aufweist, durch welche das Sicherungselement mit seinem Schraubenschaft hindurchgeführt ist.

Weiter kann es auch vorgesehen sein, dass das Sicherungselement die Form eines Exzenters aufweist. Das Sicherungselement kann dann eine von ihrer Außenumfangsfläche hervorstehende Nase aufweisen, an welcher die Betätigungsfläche ausgebildet sein kann. Bei einer Drehbewegung des Sicherungselements kann das Sicherungselement dann mit seiner Nase gegen die Tragschiene oder das Befestigungselement drücken, um die Linearbewegung zwischen dem Befestigungselement und der Tragschiene zu bewirken. In einer Endposition, in welcher die Tragschiene spielfrei an dem Befestigungselement verspannt ist, kann das Sicherungselement dann mit seiner Nase an dem Befestigungselement oder der Tragschiene eingerastet sein.

Die Sicherungseinrichtung kann beabstandet zu dem Befestigungselement angeordnet sein. Bei einer derartigen Ausgestaltung wirkt die Sicherungseinrichtung vorzugsweise unmittelbar auf die Tragschiene ein, um die Linearbewegung zwischen der Tragschiene und dem Befestigungselement zu bewirken.

Weiter ist es aber auch möglich, dass das Befestigungselement einen Aufnahmeabschnitt aufweist, an welchem die Sicherungseinrichtung angeordnet sein kann. Der Aufnahmeabschnitt kann beispielsweise ein Langloch aufweisen, durch welches das Sicherungselement der Sicherungseinrichtung geführt ist. Die Sicherungseinrichtung kann dann in das Befestigungselement integriert sein. Bei einer derartigen Ausgestaltung wirkt die Sicherungseinrichtung vorzugsweise direkt auf das Befestigungselement ein, um das Befestigungselement derart zu verschieben, dass das Befestigungselement relativ zu der Tragschiene verschoben wird, damit der Abschnitt der Tragschiene weiter in den Hintergriff eintauchen kann und darin verspannt werden kann. Das Sicherungselement der Sicherungseinrichtung kann drehbar an dem Befestigungselement gelagert sein.

Die Lösung der erfindungsgemäßen Aufgabe kann weiter durch ein Verfahren zum Befestigen einer Tragschiene an einer Fläche mittels einer wie vorstehend beschriebenen, aus- und weitergebildeten Befestigungseinrichtung gelöst werden, bei welchem das mindestens eine Befestigungselement der Befestigungseinrichtung an der Fläche befestigt wird, das mindestens eine Befestigungselement der Befestigungseinrichtung mittels seines Tragschienenbefestigungsabschnitts zumindest bereichsweise durch eine an der Tragschiene ausgebildete Öffnung hindurchgeführt wird und anschließend das Sicherungselement der Sicherungseinrichtung der Befestigungseinrichtung derart gedreht wird, dass eine Linearbewegung zwischen dem Befestigungselement und der Tragschiene derart erfolgt, dass die Tragschiene in den Hintergriff des Tragschienenbefestigungsabschnitts eingeschoben und verspannt wird.

Ferner erfolgt die Lösung der erfindungsgemäßen Aufgabe mittels einer Anordnung, welche eine Tragschiene und eine wie vorstehend beschriebene, aus- und weitergebildete Befestigungseinrichtung aufweist, wobei die Tragschiene über die Befestigungseinrichtung an der Fläche befestigt ist, um die Tragschiene an der Fläche zu halten. Vorzugsweise können entlang einer Länge der Tragschiene mehrere Befestigungselemente der Befestigungseinrichtung vorgesehen sein, so dass die Tragschiene mit einer hohen Stabilität und einer hohen Sicherheit an der Fläche befestigt werden kann. Die entlang einer Länge der Tragschiene angeordneten Befestigungselemente einer Befestigungseinrichtung sind vorzugsweise beabstandet zueinander angeordnet.

Zudem erfolgt die Lösung der erfindungsgemäßen Aufgabe mittels eines Schaltschranks, welcher mindestens eine vorstehend beschriebene, aus- und weitergebildete Anordnung aufweist, die an einer Fläche des Schaltschranks, wie beispielsweise einer Wand oder einer Montageplatte des Schaltschranks, befestigt ist.

Nachfolgend wird die Erfindung unter Bezugnahme auf die anliegenden Zeichnungen anhand bevorzugter Ausführungsformen näher erläutert.

Es zeigen
- Fig. 1: eine schematische Darstellung einer Anordnung mit einer Tragschiene und einer Befestigungseinrichtung gemäß einer Ausgestaltung der Erfindung vor der Montage der Sicherungseinrichtung,
- Fig. 2: eine schematische Schnittdarstellung der in Fig. 1 gezeigten Anordnung beim Montieren der Sicherungseinrichtung,
- Fig. 3: eine schematische Schnittdarstellung der in Fig. 1 und 2 gezeigten Anordnung mit der Sicherungseinrichtung in dem befestigten Zustand,
- Fig. 4: eine schematische Darstellung einer Anordnung mit einer Tragschiene und einer Befestigungseinrichtung gemäß einer weiteren Ausgestaltung der Erfindung bei der Montage der Sicherungseinrichtung,
- Fig. 5: eine schematische Schnittdarstellung der in Fig. 4 gezeigten Anordnung beim Montieren der Sicherungseinrichtung,
- Fig. 6: eine schematische Schnittdarstellung der in Fig. 4 und 5 gezeigten Anordnung mit der Sicherungseinrichtung in dem befestigten Zustand,
- Fig. 7: eine schematische Darstellung einer Anordnung mit einer Tragschiene und einer Befestigungseinrichtung gemäß einer weiteren Ausgestaltung der Erfindung bei der Montage der Sicherungseinrichtung,
- Fig. 8: eine schematische Schnittdarstellung der in Fig. 7 gezeigten Anordnung beim Montieren der Sicherungseinrichtung,
- Fig. 9: eine schematische Schnittdarstellung der in Fig. 7 und 8 gezeigten Anordnung mit der Sicherungseinrichtung in dem befestigten Zustand,
- Fig. 10: eine schematische Darstellung einer Anordnung mit einer Tragschiene und einer Befestigungseinrichtung gemäß einer weiteren Ausgestaltung der Erfindung bei der Montage der Sicherungseinrichtung,
- Fig. 11: eine schematische Schnittdarstellung der in Fig. 10 gezeigten Anordnung beim Montieren der Sicherungseinrichtung,
- Fig. 12: eine weitere schematische Schnittdarstellung der in Fig. 10 und 11 gezeigten Anordnung beim Montieren der Sicherungseinrichtung, und
- Fig. 13: eine schematische Schnittdarstellung der in Fig. 10 bis 12 gezeigten Anordnung mit der Sicherungseinrichtung in dem befestigten Zustand.

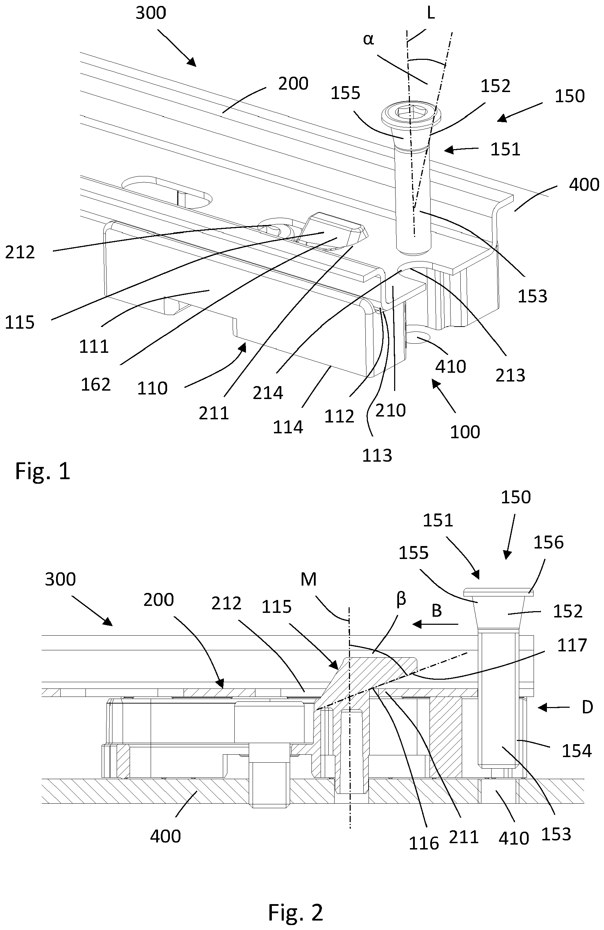

Fig. 1 bis 13 zeigen jeweils eine Anordnung 300 mit einer Tragschiene 200, welche an einer Fläche 400, wie einer Wand oder einer Montageplatte, mit einer Befestigungseinrichtung 100 befestigt wird. Zur Vereinfachung der Darstellung sind an der Tragschiene 200 aufgerastete Anschlusselement hier nicht gezeigt. Die Fläche 400 kann beispielsweise eine Wand oder eine Montageplatte eines Schaltschranks sein, in welchem die Tragschienen 200 montiert werden.

Bei allen in den Fig. 1 bis 13 gezeigten Ausgestaltungen weist die Befestigungseinrichtung 100 ein Befestigungselement 110 und eine Sicherungseinrichtung 150 auf. Entlang der Länge der Tragschiene 200 können auch mehrere derartiger Befestigungselemente 110 angeordnet sein, um die Tragschiene 200 an der Fläche 400 zu befestigen. Die Befestigungseinrichtung 100 weist hingegen vorzugsweise nur eine Sicherungseinrichtung 150, welche an einem Endabschnitt 210 der Tragschiene 200 angeordnet ist, um die Tragschiene 200 spielfrei gegen das Befestigungselement 110 bzw. gegen die mehreren Befestigungselemente 110 zu verspannen.

Das Befestigungselement 110 weist einen Grundkörper 111 auf, wobei der Grundkörper 111 die Form eines Blocks aufweist. Der Grundkörper 111 ist in dem befestigten Zustand der Tragschiene 200 an der Fläche 400 zwischen der Tragschiene 200 und der Fläche 400 angeordnet. Der Grundkörper 111 weist eine Tragschienenauflagefläche 112 auf, auf welcher die Tragschiene 200 in dem befestigten Zustand aufliegt. Die Tragschienenauflagefläche 112 weist hier im Querschnitt eine U-Form auf, in welche die Tragschiene 200 in dem befestigten Zustand eingelegt ist. Die Tragschienenauflagefläche 112 ist an einer Oberseite 113 des Grundkörpers 111 ausgebildet, wobei mit einer der Oberseite 113 gegenüberliegenden Unterseite 114 des Grundkörpers 111 der Grundkörper 111 und damit das Befestigungselement 110 an der Fläche 400 anliegt und an der Fläche 400 befestigt ist.

Das Befestigungselement 110 weist weiter einen Tragschienenbefestigungsabschnitt 115 auf. Der Tragschienenbefestigungsabschnitt 115 ist an dem Grundkörper 111 angeordnet, insbesondere einstückig angeformt.

Wie in den Schnittdarstellungen zu erkennen ist, ist an dem Tragschienenbefestigungsabschnitt 115 ein Hintergriff 116 ausgebildet, in welchen ein Abschnitt 211 der Tragschiene 200 zur Befestigung der Tragschiene 200 an dem Befestigungselement 110 eingeschoben werden kann. Der Abschnitt 211 ist unmittelbar benachbart zu der Öffnung 212, 213 der Tragschiene 200 ausgebildet, durch welchen der Tragschienenbefestigungsabschnitt 115 hindurchgeführt ist und hindurchragt.

Der Hintergriff 116 stellt einen Hinterschnitt dar. Der Hintergriff 116 ist in Form einer an der Außenumfangsfläche des Tragschienenbefestigungsabschnitts 115 ausgebildeten Aussparung ausgebildet. Die Aussparung und damit der Hintergriff 116 erstrecken sich ausgehend von der Außenumfangsfläche in Richtung einer Mittelachse M des Tragschienenbefestigungsabschnitts 111. Eine den Hintergriff 116 begrenzende Wandfläche 117 ist schräg ausgebildet, indem ich sich die Wandfläche 117 in einem Winkel β zu der Mittelachse M erstreckt. Bevorzugt ist der Winkel β 45° ≤ β ≤ 80°, besonders bevorzugt 50° ≤ β ≤ 70° groß. Durch die Aussparung kann der Tragschienenbefestigungsabschnitt 115 einen sich parallel zu der Längsachse der Tragschiene 200 erstreckenden Zapfen 162 aufweisen, an dessen im befestigten Zustand in Richtung Tragschiene 200 gerichteten Unterseite der Hintergriff 116 ausgebildet ist. Die Unterseite ist durch die Wandfläche 117 ausgebildet. Diese Wandfläche 117 und damit die Unterseite des Zapfens 162 bildet eine Rampenform, um die Tragschiene 200 mit ihrem Abschnitt 211 in den Hintergriff 116 zu führen.

Der Tragschienenbefestigungsabschnitt 115 erstreckt sich von dem Grundkörper 111 weg, so dass der Tragschienenbefestigungsabschnitt 115 in Richtung der Tragschiene 200 von dem Grundkörper 111 vorsteht. Zum Befestigen der Tragschiene 200 an der Fläche 400 taucht der Tragschienenbefestigungsabschnitt 115 durch eine Öffnung 212, 213 hindurch, damit die Tragschiene 200 mit ihrem Abschnitt 211, welcher die Öffnung 212, 213 begrenzt, an dem Hintergriff 116 einrasten bzw. hinterhaken kann.

Bei einer Montage einer Tragschiene 200 an der Fläche 400 werden zunächst die Befestigungselemente 110 der Befestigungseinrichtung 100 an der Fläche 400 befestigt.

Anschließend wird die Tragschiene 200 an den an der Fläche 400 bereits befestigten Befestigungselementen 110 befestigt. Die Tragschiene 200 wird dabei derart auf die Befestigungselemente 110 aufgesetzt, dass der Tragschienenbefestigungsabschnitt 115 durch jeweils eine an der Tragschiene 200 ausgebildete Öffnung 212, 213 hindurchgeführt wird. Zu diesem Zeitpunkt ist der Tragschienenbefestigungsabschnitt 115 noch beabstandet zu dem Abschnitt 211 der Tragschiene 200, über welchen die eigentliche Befestigung der Tragschiene 200 an dem Befestigungselement 110 erfolgt.

Um den Endzustand der Befestigung zu erreichen, erfolgt eine Verschiebebewegung der Tragschiene 200 derart, dass der Abschnitt 211 der Tragschiene 200, welcher angrenzend zu der Öffnung 212 ausgebildet ist, in den Hintergriff 116 des Tragschienenbefestigungsabschnitts 115 des Befestigungselements 110 eingeschoben wird. Bei mehreren Befestigungselementen 110 erfolgt ein zeitgleiches Einschieben der Tragschiene 200 mit dem jeweiligen Abschnitt 211 der Tragschiene 200 in den Hintergriff 116 des jeweiligen Befestigungselements 110.

Anschließend erfolgt eine Sicherung der Befestigung der Tragschiene 200 an den Befestigungselementen 110 mittels der Sicherungseinrichtung 150, indem mittels der Sicherungseinrichtung 150 die Tragschiene 200 spielfrei an den Befestigungselementen 110, insbesondere in den Hintergriffen 116 der Tragschienenbefestigungselemente 115 der Befestigungselemente 110 verspannt wird.

Bei allen in den Fig. 1 bis 13 gezeigten Ausgestaltungen weist die Sicherungseinrichtung 150 ein drehbar gelagertes Sicherungselement 151 auf, wobei durch die Drehbewegung des Sicherungselements 151 eine Linearbewegung B zwischen dem Befestigungselement 110 und der Tragschiene 200 derart erfolgt, dass die Tragschiene 200 in den Hintergriff 116 des Tragschienenbefestigungsabschnitts 115 eingeschoben und verspannt wird.

Bei der in Fig. 1 bis 3 gezeigten Ausgestaltung ist das Sicherungselement 151 in Form einer Schraube ausgebildet, welche einen Schraubenkopf 152 und einen Schraubenschaft 153 aufweist. An dem Schraubenschaft 153 ist ein Gewinde 154 ausgebildet, über welches das Sicherungselement 151 in einer an der Fläche 400 ausgebildete Öffnung 410 eingedreht und damit befestigt wird.

An dem Schraubenkopf 152 ist eine Betätigungsfläche 155 ausgebildet, welche hier mit der Tragschiene 200 zusammenwirkt, um die Tragschiene 200 weiter in den Hintergriff 116 einzuschieben und dort zu verspannen. Die Betätigungsfläche 155 ist hier in Form einer Schrägfläche ausgebildet. Die Schrägfläche weist eine Neigung auf. Die Neigung ist hier derart ausgebildet, dass zwischen einer Längsachse L der Sicherungseinrichtung 150 bzw. des Sicherungselements 151, ein Winkel α ausgebildet ist, wobei dieser Winkel α hier in etwa 30° beträgt. Die Schrägfläche erleichtert das Aufbringen einer Schiebekraft auf die Tragschiene 200 während der Drehbewegung des Sicherungselements 151, um die Linearbewegung B zwischen dem Befestigungselement 110 und der Tragschiene 200 zu bewirken. Bei einer Drehbewegung des Sicherungselements 151 wird hier das Sicherungselement 151 entlang der Längsachse L in Richtung der Fläche 400 bewegt und in diese eingeschraubt, wodurch die als Schrägfläche ausgebildete Betätigungsfläche 155 des Sicherungselements 151 eine Druckkraft D und damit eine Schiebekraft auf die Tragschiene 200 aufbringen kann, um die Tragschiene 200 mit ihrem Abschnitt 211 weiter in den Hintergriff 116 einzuschieben.

Der Schraubenkopf 152 weist hier durch die als Schrägfläche ausgebildete Betätigungsfläche 155 eine konische Form auf. Durch die konische Form kann sich die Schrägfläche um die gesamte Außenumfangsfläche des Schraubenkopfes 152 erstrecken. Die konische Form ist hier derart ausgebildet, dass sich der Schraubenkopf 162 in Richtung der Anbindung des Schraubenkopfes 152 an den Schraubenschaft 153 verjüngt. Durch die konische Form kann das Sicherungselement 151 mit seinem Schraubenkopf 152 die Tragschiene 200, umso weiter das Sicherungselement 151 in die Öffnung 410 der Fläche 400 eingedreht bzw. eingeschraubt ist, weiter in Richtung des Hintergriffs 116 verschieben und damit linear in Richtung B bewegen.

Die Tragschiene 200 weist hier an ihrem Endabschnitt 210 eine Öffnung 213 auf, welche eine U-Form aufweist. In diese Öffnung 213 greift das Sicherungselement 151 ein, um die Tragschiene 200 linear mit ihrem Schraubenkopf 152 zu verschieben. Bei der Drehbewegung des Sicherungselements 151 gleitet der Schraubenkopf 152 entlang einer die Öffnung 213 begrenzenden Kantenfläche 214 der Tragschiene 200.

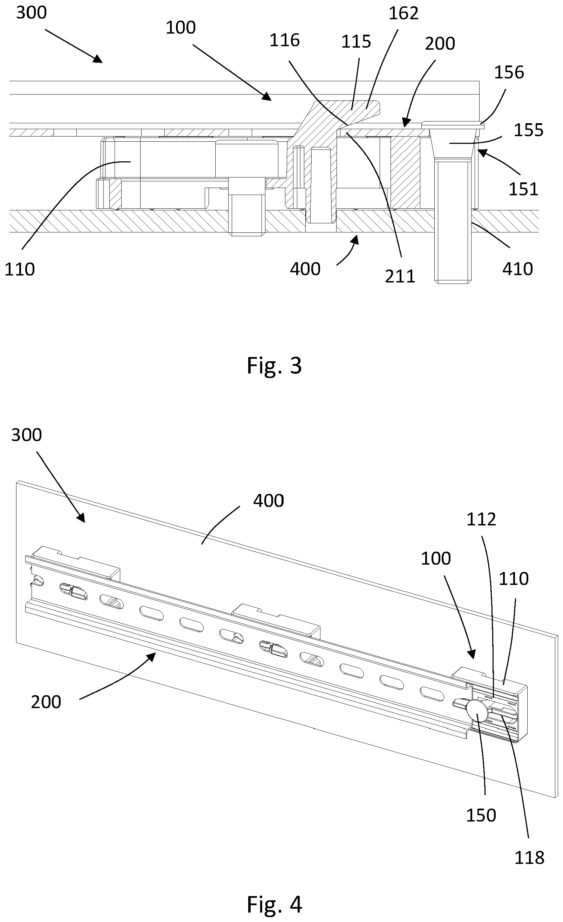

Fig. 3 zeigt den befestigten Zustand. An dem Schraubenkopf 152 ist ein den Schraubenkopf 152 überlappender Kragen 156 angeformt, welcher in dem befestigten Zustand auf der Tragschiene 200 aufliegt und damit ein zu weites Eindrehen des Sicherungselements 152 verhindern kann. In diesem befestigten Zustand ist das Sicherungselement 151 mit seiner Betätigungsfläche 155 gegen die Kantenfläche 214 der Tragschiene 200 verspannt, um die Tragschiene 200 in dem Hintergriff 116 spielfrei verspannen zu können, wie in Fig. 3 zu erkennen ist.

Fig. 4 bis 6 zeigt eine weitere Ausgestaltung einer Sicherungseinrichtung 150. Auch hier ist das Sicherungselement 151 der Sicherungseinrichtung 150 in Form einer Schraube ausgebildet. An dem Schraubenkopf 152 des Sicherungselements 151 ist die Betätigungsfläche 155 ausgebildet, wobei die Betätigungsfläche 155 auch hier als eine Schrägfläche ausgebildet ist. Der Schraubenkopf 152 weist damit auch hier eine konische Form auf.

Im Gegensatz zu der in Fig. 1 bis 3 gezeigten Ausgestaltung ist bei der in Fig. 4 bis 6 gezeigten Ausgestaltung die Sicherungseinrichtung 150 nicht beabstandet zu dem Befestigungselement 110 angeordnet, sondern das Befestigungselement 110 weist einen Aufnahmeabschnitt 118 auf, in welchen die Sicherungseinrichtung 150 aufgenommen ist. Der Aufnahmeabschnitt 118 ist hier in Form eines Langlochs ausgebildet. Durch die Ausbildung des Aufnahmeabschnitts 118 als Langloch ist eine Verschiebebewegung des Befestigungselements 110 relativ zu der Sicherungseinrichtung 150 zur Ausführung der Linearbewegung B möglich. Bei dieser Ausgestaltung erfolgt damit durch eine Drehbewegung des Sicherungselements 151 der Sicherungseinrichtung 150 eine Linearverschiebung des Befestigungselements 150 in Richtung des Abschnitts 211 der Tragschiene 200, damit dieser weiter in den Hintergriff 116 eintauchen kann.

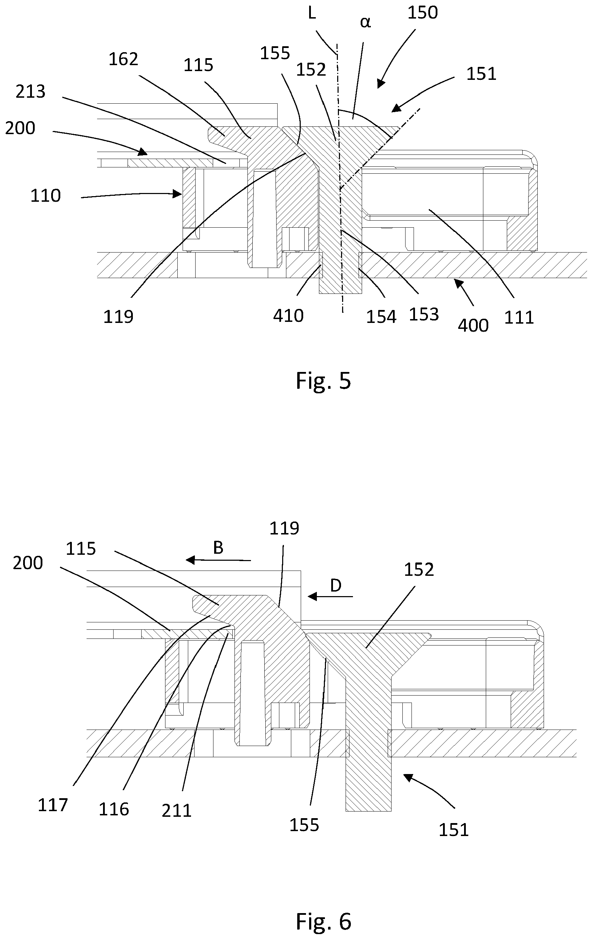

Bei einer Drehbewegung des Sicherungselements 151 wirkt dieses hier unmittelbar auf den Tragschienenbefestigungsabschnitt 115 ein, um das Befestigungselement 110 linear zu verschieben. An dem Tragschienenbefestigungsabschnitt 115 ist dafür eine Gleitfläche 119 ausgebildet, entlang welcher das Sicherungselement 151 mit seinem Schraubenkopf 152 bei einer Drehbewegung des Sicherungselements 151 entlanggleiten kann, wie in Fig. 5 und 6 zu erkennen ist.

Die Gleitfläche 119 weist die gleiche Neigung auf, wie die Betätigungsfläche 155 des Sicherungselements 151, so dass auch die Gleitfläche 119 in Form einer Schrägfläche ausgebildet ist. Gleitet das Sicherungselement 151 mit seiner Betätigungsfläche 155 entlang der Gleitfläche 119 nach unten, um in der Öffnung 410 der Fläche 400 eingeschraubt zu werden, übt das Sicherungselement 152 eine Druckkraft D auf den Tragschienenbefestigungsabschnitt 115 aus, um diesen und damit das Befestigungselement 110 weiter in Richtung des Abschnitts 211 der Tragschiene 200 zu schieben, damit dieses tiefer in den Hintergriff 116 eingreifen und darin verspannt werden kann, wie in Fig. 6 gezeigt ist.

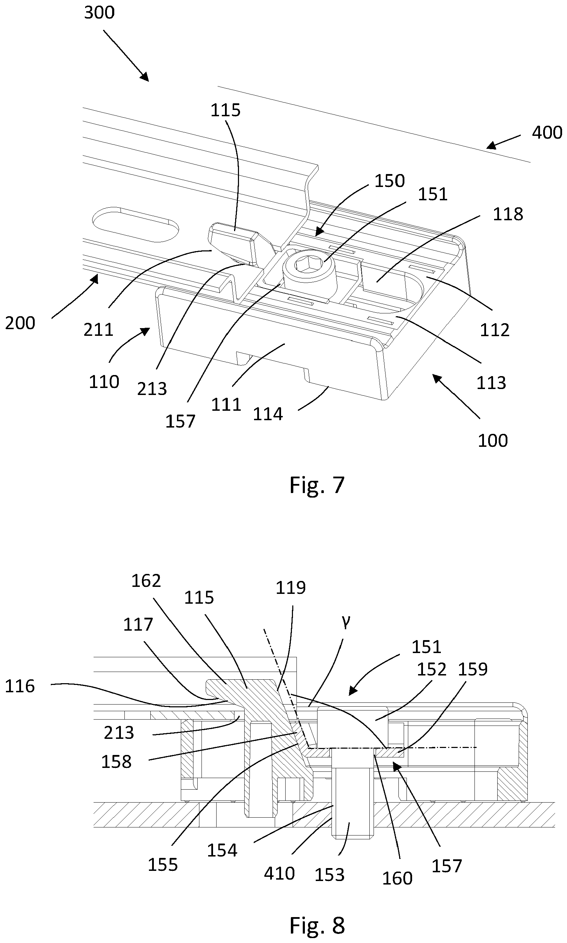

Bei der in Fig. 7 bis 9 gezeigten Ausgestaltung weist die Sicherungseinrichtung 150 zusätzlich zu dem Sicherungselement 151 ein Betätigungselement 157 auf. Die Betätigungsfläche 155 ist hier an dem Betätigungselement 157 und nicht an dem Sicherungselement 151 ausgebildet. Das Sicherungselement 151 wirkt damit hier indirekt auf das Befestigungselement 110, um eine Linearbewegung B zwischen dem Befestigungselement 110 und der Tragschiene 200 zu bewirken.

Das Sicherungselement 151 ist hier in Form einer handelsüblichen Schraube ausgebildet. Das Sicherungselement 151 ist hier, genauso wie bei der in Fig. 4 bis 6 gezeigten Ausgestaltung an dem Aufnahmeabschnitt 118 des Befestigungselements 110 angeordnet. Der Aufnahmeabschnitt 118 ist auch hier in Form eines Langlochs ausgebildet. Durch die Ausbildung des Aufnahmeabschnitts 118 als Langloch ist eine Verschiebebewegung des Befestigungselements 110 relativ zu der Sicherungseinrichtung 150 zur Ausführung der Linearbewegung B möglich. Bei dieser Ausgestaltung erfolgt damit durch eine Drehbewegung des Sicherungselements 151 der Sicherungseinrichtung 150 das Aufbringen einer Druckkraft auf das Betätigungselement 157, wodurch das Betätigungselement 157 entlang des Tragschienenbefestigungsabschnitts 115 gleitet und dadurch eine Druckkraft D derart auf den Tragschienenbefestigungsabschnitt 115 aufbringt, dass eine Linearbewegung B des Befestigungselements 150 in Richtung des Abschnitts 211 der Tragschiene 200 erfolgt, damit dieser weiter in den Hintergriff 116 eintauchen kann.

Das Betätigungselement 157 ist an dem Sicherungselement 151 angeordnet. Das Betätigungselement 157 ist ein Stanz-Biegeteil, welches aus einem Blech ausgebildet sein kann.

Das Betätigungselement 157 weist einen ersten Schenkel 158 auf, an welchem die Betätigungsfläche 155 ausgebildet ist. Weiter weist das Betätigungselement 157 einen zweiten Schenkel 159 auf, über welchen das Betätigungselement 157 an dem Sicherungselement 151 angeordnet ist. Der erste Schenkel 158 ist zu dem zweiten Schenkel 159 mit einem Winkel γ abgewinkelt ausgebildet. Der Winkel γ beträgt zwischen 100° ≤ γ ≤ 170°, bevorzugt zwischen 110° ≤ γ ≤ 150°. Durch die Abwinklung des ersten Schenkels 158 ist die an dem ersten Schenkel 158 ausgebildete Betätigungsfläche 155 als Schrägfläche ausgebildet. Mit der Betätigungsfläche 155 gleitet der erste Schenkel 158 des Betätigungselements 157 bei einer Drehbewegung des Sicherungselements 151 entlang der Gleitfläche 119 des Tragschienenbefestigungsabschnitts 115. Der Tragschienenbefestigungsabschnitt 115 ist bei der in Fig. 7 bis 9 gezeigten Ausgestaltung gleich zu der in Fig. 4 bis 6 gezeigten Ausgestaltung ausgebildet.

An dem zweiten Schenkel 159 des Betätigungselements 157 ist eine Öffnung 160 ausgebildet, durch welche das Sicherungselement 151 mit seinem Schraubenschaft 153 hindurchragt. Mit dem Schraubenkopf 152 liegt das Sicherungselement 151 auf einer Oberseite des zweiten Schenkels 159 auf, so dass bei einer Drehbewegung des Sicherungselements 151 zum Befestigen an der Fläche 400 das Sicherungselement 151 das Betätigungselement 157 mitführt in Richtung der Fläche 400.

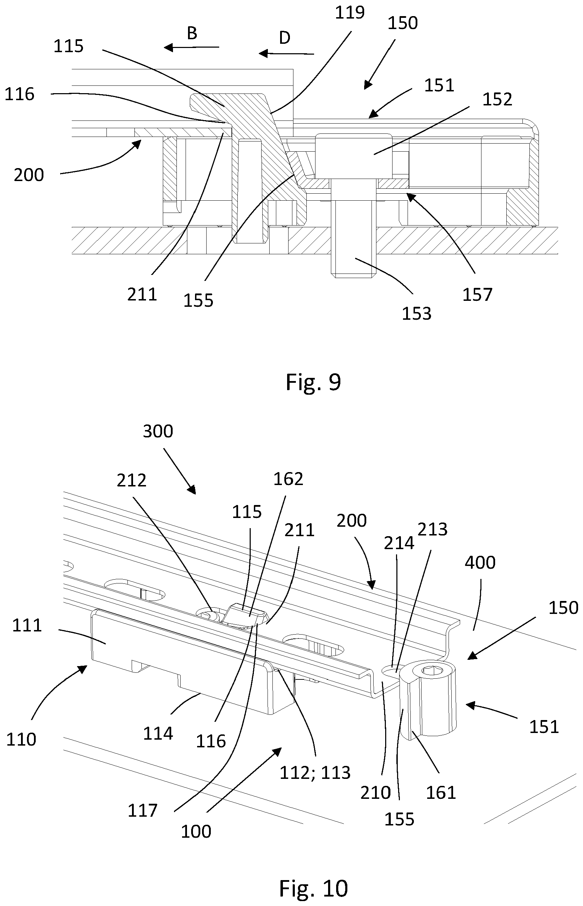

In Fig. 10 bis 13 ist eine weitere Ausgestaltung gezeigt, bei welcher das Sicherungselement 151 eine exzentrische Form aufweist. Das Sicherungselement 151 und damit die Sicherungseinrichtung 150 ist hier beabstandet zu dem Befestigungselement 110 angeordnet. Die Sicherungseinrichtung 150 wirkt unmittelbar auf die Tragschiene 200 ein, um diese weiter in den Hintergriff 116 des Tragschienenbefestigungsabschnitts 115 einzuschieben und damit darin verspannen zu können.

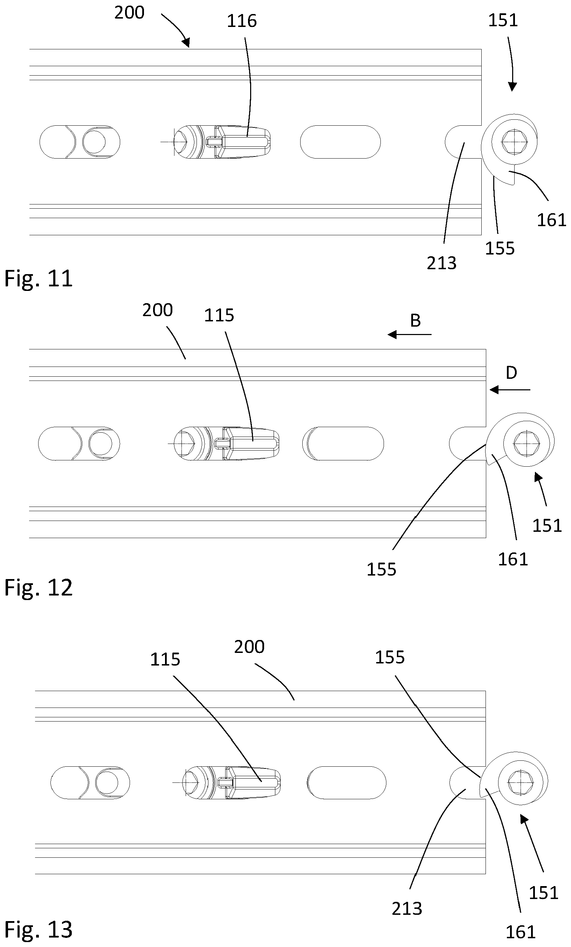

Das Sicherungselement 151 weist eine zylindrische Grundform auf, wobei eine von der Außenumfangsfläche der Grundform hervorstehende Nase 161 vorgesehen ist, an welcher die Betätigungsfläche 155 ausgebildet ist. Bei einer Drehbewegung des Sicherungselements 151 kann das Sicherungselement 151 mit seiner Nase 161 gegen die Tragschiene 200 bzw. gegen den Endabschnitt 210 der Tragschiene 200 eine Drucckraft D aufbringen, um die Linearbewegung B zwischen dem Befestigungselement 110 und der Tragschiene 200 zu bewirken. In einer Endposition, welche in Fig. 13 gezeigt ist, in welcher die Tragschiene 200 spielfrei an dem Befestigungselement 110 verspannt ist, ist das Sicherungselement 151 mit seiner Nase 161 an der Tragschiene 200 eingerastet, indem die Nase 161 in die Öffnung 213 eintaucht und darin verrastet ist.

### Bezugszeichenliste

- 100: Befestigungseinrichtung
- 110: Befestigungselement
- 111: Grundkörper
- 112: Tragschienenauflagefläche
- 113: Oberseite
- 114: Unterseite
- 115: Tragschienenbefestigungsabschnitt
- 116: Hintergriff
- 117: Wandfläche
- 118: Aufnahmeabschnitt
- 119: Gleitfläche
- 150: Sicherungseinrichtung
- 151: Sicherungselement
- 152: Schraubenkopf
- 153: Schraubenschaft
- 154: Gewinde
- 155: Betätigungsfläche
- 156: Kragen
- 157: Betätigungselement
- 158: Erster Schenkel
- 159: Zweiter Schenkel
- 160: Öffnung
- 161: Nase
- 162: Zapfen

- 200: Tragschiene
- 210: Endabschnitt
- 211: Abschnitt
- 212: Öffnung
- 213: Öffnung
- 214: Kantenfläche

- 300: Anordnung
- 400: Fläche
- 410: Öffnung

- L: Längsachse
- B: Linearbewegung
- M: Mittelachse
- D: Druckkraft
- α: Winkel
- β: Winkel
- γ: Winkel

## Patentansprüche

1. Befestigungseinrichtung (100) zum Befestigen einer Tragschiene (200) an einer Fläche (400), mit einem an der Fläche (400) befestigbaren Befestigungselement (110), welches eine Tragschienenauflagefläche (112) zur Auflage der Tragschiene (200) und einen Tragschienenbefestigungsabschnitt (115) aufweist, wobei der Tragschienenbefestigungsabschnitt (115) in einem befestigten Zustand zumindest bereichsweise durch eine an der Tragschiene (200) ausgebildete Öffnung (212, 213) hindurchgeführt ist und wobei der Tragschienenbefestigungsabschnitt (115) einen Hintergriff (116) aufweist, in welchen in dem befestigten Zustand ein Abschnitt (211) der Tragschiene (200) eingeschoben ist, und mit einer Sicherungseinrichtung (150), wobei die Sicherungseinrichtung (150) ein Sicherungselement (151) aufweist, **dadurch gekennzeichnet, dass** das Sicherungselement derart ausgebildet ist, dass durch eine Drehbewegung des Sicherungselements (151) eine Linearbewegung (B) zwischen dem Befestigungselement (110) und der Tragschiene (200) derart erfolgt, dass die Tragschiene (200) in den Hintergriff (116) des Tragschienenbefestigungsabschnitts (115) eingeschoben und verspannt wird.

2. Befestigungseinrichtung (100) nach Anspruch 1, wobei die Sicherungseinrichtung (150) eine Betätigungsfläche (155) aufweist, welche mit dem Befestigungselement (110) oder der Tragschiene (200) zusammenwirkt, um die Linearbewegung (B) zu bewirken.

3. Befestigungseinrichtung (100) nach Anspruch 2, wobei die Betätigungsfläche (155) in Form einer Schrägfläche ausgebildet ist.

4. Befestigungseinrichtung (100) nach Anspruch 2 oder 3, wobei das Befestigungselement (110) eine Gleitfläche (119) aufweist, welche mit der Betätigungsfläche (155) der Sicherungseinrichtung (150) zusammenwirkt.

5. Befestigungseinrichtung (100) nach Anspruch 4, wobei die Gleitfläche (119) an dem Tragschienenbefestigungsabschnitt (115) ausgebildet ist.

6. Befestigungseinrichtung (100) nach einem der Ansprüche 1 bis 5, wobei das Sicherungselement (151) eine Schraube ist

7. Befestigungseinrichtung (100) nach Anspruch 6, wobei die Schraube einen Schraubenkopf (152) aufweist, wobei die Betätigungsfläche (155) an dem Schraubenkopf (152) ausgebildet ist.

8. Befestigungseinrichtung (100) nach Anspruch 7, wobei der Schraubenkopf (152) eine konische Form aufweist.

9. Befestigungseinrichtung (100) nach einem der Ansprüche 1 bis 7, wobei die Sicherungseinrichtung (150) ein an dem Sicherungselement (151) angeordnetes Betätigungselement (157) aufweist, an welchem die Betätigungsfläche (155) ausgebildet ist.

10. Befestigungseinrichtung (100) nach Anspruch 9, wobei das Betätigungselement (157) einen ersten Schenkel (158) aufweist, über welchen das Betätigungselement (157) an dem Sicherungselement (151) angeordnet ist, und das Betätigungselement (157) einen zweiten Schenkel (159) aufweist, an welchem die Betätigungsfläche (155) ausgebildet ist, wobei der zweite Schenkel (159) zu dem ersten Schenkel (158) abgewinkelt angeordnet ist.

11. Befestigungseinrichtung (100) nach Anspruch 1 oder 2, wobei das Sicherungselement (151) eine von ihrer Außenumfangsfläche hervorstehende Nase (161) aufweist, an welcher die Betätigungsfläche (155) ausgebildet ist.

12. Befestigungseinrichtung (100) nach einem der Ansprüche 1 bis 11, wobei die Sicherungseinrichtung (150) beabstandet zu dem Befestigungselement (110) angeordnet ist.

13. Befestigungseinrichtung (100) nach einem der Ansprüche 1 bis 11, wobei das Befestigungselement (110) einen Aufnahmeabschnitt (118) aufweist, an welchem die Sicherungseinrichtung (150) angeordnet ist.

14. Verfahren zum Befestigen einer Tragschiene (200) an einer Fläche (400) mittels einer Befestigungseinrichtung (100) nach einem der Ansprüche 1 bis 13, bei welchem das mindestens eine Befestigungselement (110) der Befestigungseinrichtung (100) an der Fläche (400) befestigt wird, das mindestens eine Befestigungselement (110) der Befestigungseinrichtung (100) mittels seines Tragschienenbefestigungsabschnitts (115) zumindest bereichsweise durch eine an der Tragschiene (200) ausgebildete Öffnung (212, 213) hindurchgeführt wird und anschließend das Sicherungselement (151) der Sicherungseinrichtung (150) der Befestigungseinrichtung (100) derart gedreht wird, dass eine Linearbewegung (B) zwischen dem Befestigungselement (110) und der Tragschiene (200) derart erfolgt, dass die Tragschiene (200) in den Hintergriff (116) des Tragschienenbefestigungsabschnitts (115) eingeschoben und verspannt wird.

15. Anordnung (300), mit einer Tragschiene (200) und mit einer nach einem der Ansprüche 1 bis 13 ausgebildeten Befestigungseinrichtung (100), wobei die Tragschiene (200) über die Befestigungseinrichtung (100) an der Fläche (400) befestigt ist.

16. Schaltschrank, mit mindestens einer Anordnung (300) nach Anspruch 15, welche an einer Fläche (400) des Schaltschranks befestigt ist.

## Claims

1. Fastening device (100) for fastening a carrying rail (200) to a surface (400), having a fastening element (110) which is able to be fastened to the surface (400) and has a carrying-rail-supporting surface (112), for supporting the carrying rail (200), and a carrying-rail-fastening portion (115), wherein, in a fastened state, the carrying-rail-fastening portion (115) is passed at least regionally through an opening (212, 213) formed in the carrying rail (200), and wherein the carrying-rail-fastening portion (115) has an undercut (116) into which, in the fastened state, a portion (211) of the carrying rail (200) is pushed, and having a securing device (150), wherein the securing device (150) has a securing element (151), **characterized in that** the securing element is designed in such a way that, by way of a turning movement of the securing element (151), a linear movement (B) between the fastening element (110) and the carrying rail (200) is realized in such a way that the carrying rail (200) is pushed into the undercut (116) of the carrying-rail-fastening portion (115) and braced therein.

2. Fastening device (100) according to Claim 1, wherein the securing device (150) has an actuating surface (155) which interacts with the fastening element (110) or the carrying rail (200) in order for the linear movement (B) to be effected.

3. Fastening device (100) according to Claim 2, wherein the actuating surface (155) is in the form of an oblique surface.

4. Fastening device (100) according to Claim 2 or 3, wherein the fastening element (110) has a sliding surface (119) which interacts with the actuating surface (155) of the securing device (150).

5. Fastening device (100) according to Claim 4, wherein the sliding surface (119) is formed on the carrying-rail-fastening portion (115).

6. Fastening device (100) according to one of Claims 1 to 5, wherein the securing element (151) is a screw.

7. Fastening device (100) according to Claim 6, wherein the screw has a screw head (152), wherein the actuating surface (155) is formed on the screw head (152) .

8. Fastening device (100) according to Claim 7, wherein the screw head (152) has a conical shape.

9. Fastening device (100) according to one of Claims 1 to 7, wherein the securing device (150) has an actuating element (157) which is arranged on the securing element (151) and on which the actuating surface (155) is formed.

10. Fastening device (100) according to Claim 9, wherein the actuating element (157) has a first limb (158), via which the actuating element (157) is arranged on the securing element (151), and the actuating element (157) has a second limb (159), on which the actuating surface (155) is formed, wherein the second limb (159) is arranged at an angle to the first limb (158).

11. Fastening device (100) according to Claim 1 or 2, wherein the securing element (151) has a nose (161) which projects from the outer circumferential surface thereof and on which the actuating surface (155) is formed.

12. Fastening device (100) according to one of Claims 1 to 11, wherein the securing device (150) is arranged spaced apart from the fastening element (110).

13. Fastening device (100) according to one of Claims 1 to 11, wherein the fastening element (110) has a receiving portion (118) in which the securing device (150) is arranged.

14. Method for fastening a carrying rail (200) to a surface (400) by means of a fastening device (100) according to one of Claims 1 to 13, in which the at least one fastening element (110) of the fastening device (100) is fastened to the surface (400), the at least one fastening element (110) of the fastening device (100) is, by means of the carrying-rail-fastening portion (115) thereof, passed at least regionally through an opening (212, 213) formed in the carrying rail (200), and subsequently the securing element (151) of the securing device (150) of the fastening device (100) is turned in such a way that a linear movement (B) between the fastening element (110) and the carrying rail (200) is realized in such a way that the carrying rail (200) is pushed into the undercut (116) of the carrying-rail-fastening portion (115) and braced therein.

15. Arrangement (300) having a carrying rail (200) and having a fastening device (100) designed according to one of Claims 1 to 13, wherein the carrying rail (200) is fastened to the surface (400) via the fastening device (100).

16. Control cabinet having at least one arrangement (300) according to Claim 15 which is fastened to a surface (400) of the control cabinet.

## Revendications

1. Dispositif de fixation (100) pour la fixation d'un rail porteur (200) à une surface (400), avec un élément de fixation (110) pouvant être fixé à la surface (400), qui présente une surface d'appui de rail porteur (112) pour l'appui du rail porteur (200) et une section de fixation de rail porteur (115), la section de fixation de rail porteur (115) étant passée, dans un état fixé, au moins par zones, à travers une ouverture (212, 213) réalisée sur le rail porteur (200), et la section de fixation de rail porteur (115) présentant une prise arrière (116) dans laquelle une section (211) du rail porteur (200) est insérée à l'état fixé, et avec un dispositif de sécurité (150), le dispositif de sécurité (150) présentant un élément de sécurité (151), **caractérisé en ce que** l'élément de sécurité est réalisé de telle sorte que, par un mouvement de rotation de l'élément de sécurité (151), un mouvement linéaire (B) entre l'élément de fixation (110) et le rail porteur (200) est effectué de telle sorte que le rail porteur (200) est inséré et serré dans la prise arrière (116) de la section de fixation de rail porteur (115).

2. Dispositif de fixation (100) selon la revendication 1, dans lequel le dispositif de sécurité (150) présente une surface d'actionnement (155) qui coopère avec l'élément de fixation (110) ou le rail porteur (200) afin de provoquer le mouvement linéaire (B).

3. Dispositif de fixation (100) selon la revendication 2, dans lequel la surface d'actionnement (155) est réalisée sous la forme d'une surface oblique.

4. Dispositif de fixation (100) selon la revendication 2 ou 3, dans lequel l'élément de fixation (110) présente une surface de glissement (119) qui coopère avec la surface d'actionnement (155) du dispositif de sécurité (150) .

5. Dispositif de fixation (100) selon la revendication 4, dans lequel la surface de glissement (119) est réalisée sur la section de fixation de rail porteur (115) .

6. Dispositif de fixation (100) selon l'une quelconque des revendications 1 à 5, dans lequel l'élément de sécurité (151) est une vis.

7. Dispositif de fixation (100) selon la revendication 6, dans lequel la vis présente une tête de vis (152), la surface d'actionnement (155) étant réalisée sur la tête de vis (152).

8. Dispositif de fixation (100) selon la revendication 7, dans lequel la tête de vis (152) présente une forme conique.

9. Dispositif de fixation (100) selon l'une quelconque des revendications 1 à 7, dans lequel le dispositif de sécurité (150) présente un élément d'actionnement (157) agencé sur l'élément de sécurité (151), sur lequel est réalisée la surface d'actionnement (155).

10. Dispositif de fixation (100) selon la revendication 9, dans lequel l'élément d'actionnement (157) présente une première branche (158) par l'intermédiaire de laquelle l'élément d'actionnement (157) est agencé sur l'élément de sécurité (151), et l'élément d'actionnement (157) présente une deuxième branche (159) sur laquelle est réalisée la surface d'actionnement (155), la deuxième branche (159) étant agencée en formant un angle avec la première branche (158).

11. Dispositif de fixation (100) selon la revendication 1 ou 2, dans lequel l'élément de sécurité (151) présente un ergot (161) faisant saillie de sa surface périphérique extérieure, sur lequel est réalisée la surface d'actionnement (155).

12. Dispositif de fixation (100) selon l'une quelconque des revendications 1 à 11, dans lequel le dispositif de sécurité (150) est agencé à distance de l'élément de fixation (110).

13. Dispositif de fixation (100) selon l'une quelconque des revendications 1 à 11, dans lequel l'élément de fixation (110) présente une section de réception (118), sur laquelle est agencé le dispositif de sécurité (150).

14. Procédé de fixation d'un rail porteur (200) à une surface (400) au moyen d'un dispositif de fixation (100) selon l'une quelconque des revendications 1 à 13, dans lequel l'au moins un élément de fixation (110) du dispositif de fixation (100) est fixé à la surface (400), l'au moins un élément de fixation (110) du dispositif de fixation (100) est passé au moins par zones, au moyen de sa section de fixation de rail porteur (115), à travers une ouverture (212, 213) réalisée sur le rail porteur (200) et ensuite l'élément de sécurité (151) du dispositif de sécurité (150) du dispositif de fixation (100) est tourné de telle sorte qu'un mouvement linéaire (B) entre l'élément de fixation (110) et le rail porteur (200) est effectué, de telle sorte que le rail porteur (200) est inséré et serré dans la prise arrière (116) de la section de fixation de rail porteur (115).

15. Agencement (300), avec un rail porteur (200) et avec un dispositif de fixation (100) réalisé selon l'une quelconque des revendications 1 à 13, le rail porteur (200) étant fixé à la surface (400) par l'intermédiaire du dispositif de fixation (100).

16. Armoire électrique, avec au moins un agencement (300) selon la revendication 15, qui est fixé à une surface (400) de l'armoire électrique.
